# EUROPEAN PATENT SPECIFICATION

(11) **EP 3 091 417 B1**
(45) Date of publication and mention of the grant of the patent: **17.10.2018**
(21) Application number: 15180922.5
(22) Date of filing: 13.08.2015
(51) Int. Cl.: G05D 22/02, H05K 5/02, H05K 7/20

(54) **ELECTRICAL ASSEMBLY COMPRISING MEANS FOR HUMIDITY PREVENTION**
ELEKTRISCHE BAUGRUPPE MIT MITTELN ZUR FEUCHTIGKEITSPRÄVENTION
ENSEMBLE ELECTRIQUE COMPRENANT DES MOYENS DE PREVENTION DE L'HUMIDITE

(30) Priority: 29.04.2015 EP 15165693
(43) Date of publication of application: 09.11.2016
(73) Proprietor: ABB Schweiz AG, 5400 Baden (CH)
(72) Inventor: Kokkonen, Jesse, 00380 Helsinki (FI); Myller, Mikko, 00380 Helsinki (FI); Jussila, Matti T., 00380 Helsinki (FI)
(74) Representative: Kolster Oy Ab

(56) References cited:
- EP-A1- 0 668 554
- US-A1- 2010 078 494

## Description

### FIELD OF THE INVENTION

The present invention relates to an electrical assembly comprising means for humidity prevention.

An electrical assembly for outdoor use is often equipped with humidity prevention means or dehumidification means. A known electrical assembly comprises heating resistor means located inside a housing of the electrical assembly, the heating resistor means being adapted for heating inside the housing in order to reduce relative humidity inside the housing. The heating resistor means is controlled by a humidistat or a thermostat, or by a combination thereof. One of the disadvantages associated with the above electrical assembly is that the heating resistor means is expensive. Further, the heating resistor means requires plenty of space inside the housing. Document EP 0668554 discloses a known electrical assembly, in which a control unit is adapted to perform a humidity prevention action.

### BRIEF DESCRIPTION OF THE INVENTION

An object of the present invention is to provide an electrical assembly so as to alleviate the above disadvantages. The objects of the invention are achieved by an electrical assembly and a method which are characterized by what is stated in the independent claims. Preferred embodiments of the invention are disclosed in the dependent claims.

The invention is based on the realization that fan means inside a housing of an electrical assembly can be utilized for heating inside the housing, wherein the heating effect is based on the fact that substantially the entire input power of the fan means is converted into heat inside the housing as long as the air flow of the fan means is confined to inside the housing. Both waste heat of a fan means and friction losses of an air flow generated by the fan means heat inside a housing in which the fan means is located if the housing is closed or substantially closed. Therefore a fan means whose primary function is to provide an air flow for cooling the electrical assembly can be utilized as a part of heating means for humidity prevention purposes. Humidity prevention is carried out or at least assisted by increasing power of a fan means.

An advantage of the electrical assembly of the invention is that a conventional heating resistor can be designed smaller or a conventional heating resistor can be omitted completely since humidity can be prevented by a fan means that originally was designed for purposes other than heating. Such a smaller heating resistor is cheaper and requires less space than a conventional heating resistor designed to prevent humidity by itself.

### BRIEF DESCRIPTION OF THE DRAWINGS

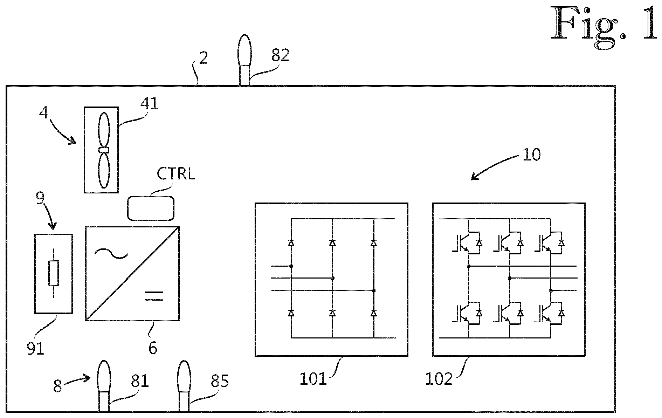

In the following the invention will be described in greater detail by means of preferred embodiments with reference to the attached Figure 1 which shows an electrical assembly according to an embodiment of the invention.

### DETAILED DESCRIPTION OF THE INVENTION

Figure 1 shows an electrical assembly comprising a housing 2, a fan means 4, a power supply 6, a sensor means 8, a control means CTRL, a heating resistor means 9, and a power conversion means 10. The housing 2 is a substantially closed housing.

The fan means is 4 adapted to generate an air flow inside the housing 2. The fan means 4 comprises a first fan 41.

The power supply 6 is adapted to supply power to the fan means 4. The power supply 6 is a separate device located inside the housing 2. In an alternative embodiment a first fan comprises an integrated power supply. In a further alternative embodiment a first fan is adapted to be supplied directly from an alternating current network or from a direct current network so that a power supply is not necessary.

The power conversion means 10 comprises a frequency converter having a rectifier unit 101 and an inverter unit 102. In an alternative embodiment, a power conversion means comprises a DC-to-DC converter, an inverter, or some other assembly adapted to convert electric energy from one form to another. In a further alternative embodiment the electrical assembly does not comprise a power conversion means.

The sensor means 8 comprises a first temperature sensor 81, a second temperature sensor 82, and a humidity sensor 85, each one of which is adapted to send information to the control means CTRL. The first temperature sensor 81 is adapted to detect temperature inside the housing 2, the second temperature sensor 82 is adapted to detect ambient temperature present outside the housing 2, and the humidity sensor 85 is adapted to detect humidity inside the housing 2.

In an embodiment, a humidity sensor is adapted to detect relative humidity. In alternative embodiments, a humidity sensor is adapted to detect absolute humidity or specific humidity, for example. Herein humidity prevention and dehumidification mean actions that reduce relative humidity inside the housing. The purpose of humidity prevention or dehumidification is to prevent water from condensing into a liquid inside the housing. Therefore, humidity prevention or dehumidification does not necessarily remove water from the housing.

The control means CTRL is adapted to receive information from the sensor means 8, and to control the power supply 6, the fan means 4, the heating resistor means 9 and the power conversion means 10. The control means CTRL is adapted to perform at least one humidity prevention action in a predetermined humidity situation detected based on the information received from the sensor means 8. In an embodiment existence of a predetermined humidity situation is decided by comparing detected conditions inside the housing to at least one limit value.

The at least one humidity prevention action comprises increasing power of the fan means 4. Increasing power of the fan means 4 increases waste heat of the fan means 4 and friction losses of an air flow generated by the fan means 4, thereby generating extra heat which is utilized for dehumidification. Also a waste heat of the power supply 6 is utilized for dehumidification. In an embodiment the at least one humidity prevention action comprises starting the fan means when a predetermined humidity situation occurs while the fan means is in OFF state. In another embodiment the at least one humidity prevention action comprises increasing a rotation speed of a slowly rotating fan, the slow rotation speed being below the nominal speed of the fan. A fan may be rotating slowly due to a minor need for cooling or in order to maintain bearings of the fan in working condition during a cold weather.

The heating resistor means 9 comprises a heating resistor 91. The heating resistor 91 is located inside the housing 2 and adapted for heating inside the housing 2. In an alternative embodiment, the heating resistor means comprises a controllable heating resistor wherein the control means is adapted to control power of the controllable heating resistor.

A power of at least one humidity prevention action can be controlled by controlling power of the fan means 4 and/or power of the heating resistor means 9. A dehumidification process can be carried out or assisted by controlling the fan means 4. In some embodiments, a conventional heating resistor means can be omitted completely and at least one humidity prevention action can be carried out by a fan means.

In alternative embodiments, the at least one humidity prevention action comprises additionally turning on the power conversion means and/or turning on the heating resistor means at least partially. In an embodiment, the at least one humidity prevention action comprises controlling the power of the fan means as a response to the information received from the sensor means such that the power of the fan means is increased if humidity increases despite the fan means is running at a power level lower than the maximum power of the fan means. In another embodiment, the at least one humidity prevention action comprises controlling the power of the fan means such that a target is to maintain relative humidity inside the housing below a predetermined humidity limit value selected from a range of 40 - 90%, for example. If relative humidity inside the housing drops sufficiently below the predetermined humidity limit value, the fan means is no longer utilized for humidity prevention and the fan means is turned off unless the fan means needs to be running for other purposes such as for cooling.

The control means CTRL is adapted to store information about operating temperature ranges of the fan means 4, the power supply 6, and the power conversion means 10, and to utilize said information when selecting a humidity prevention action. The control means CTRL is adapted to realize at least one humidity prevention action with electrical devices whose operating temperature ranges allow them to be turned on at the time in question. For example, if a predetermined humidity situation is detected at a time when temperature inside the housing is -38°C, and the lowest operating temperature of a fan means is -40°C and the lowest operating temperature of a power conversion means is -20°C, the control means is adapted to begin at least one humidity prevention action by increasing power of the fan means and optionally by turning on the heating resistor means at least partially. When the temperature inside the housing reaches -20°C, the control means turns on the power conversion means, provided that a predetermined humidity situation is still present.

In an embodiment, the control means is adapted to eliminate a predetermined humidity situation as fast as possible. In such an embodiment, the control means is adapted to keep all available electrical devices at maximum power until the predetermined humidity situation is over.

A predetermined humidity situation is present when humidity inside the housing 2 exceeds a predetermined humidity limit value. As a response to a detected humidity situation, the control means CTRL increases power of the fan means 4. Increasing power of the fan means 4 reduces relative humidity inside the housing 2 since substantially the entire input power of the fan means 4 is converted into heat inside the housing 2. The housing 2 is an enclosed housing such that there is substantially no air flow between the inside of the housing 2 and the outside of the housing 2. Therefore an air flow generated by the fan means 4 is substantially confined to inside the housing 2 and substantially no energy escapes from the housing with air leaks. The fan means 4 not only provides heat dehumidifying air inside the housing 2 but also mixes air inside the housing 2, thereby evening out humidity conditions in different portions of the housing 2.

Another predetermined humidity situation is present when a difference between a temperature inside the housing 2 and an ambient temperature is less than a predetermined temperature difference limit value. Said predetermined temperature difference limit value may be in the range of 0 to 15°C, wherein a temperature inside the housing is higher than or equal to an ambient temperature. This type of indirect detection of a potential humidity problem can be used as an alternative to direct humidity detection or as a complementary method.

In an embodiment a housing of an electrical assembly comprises at least one ventilation opening for situations where a fan means cools the electrical assembly. The at least one ventilation opening provides a path for an air flow between inside the housing and outside the housing. A housing provided with at least one ventilation opening can be equipped with shutter means adapted to substantially close the at least one ventilation opening, wherein the control means is adapted to control the shutter means and to keep the at least one ventilation opening closed during at least one humidity prevention action.

In alternative embodiments, the sensor means and the control means are at least partially integrated, wherein the electrical assembly comprises condition-sensitive switch means adapted to control the fan means, the condition-sensitive switch means comprising a humidistat or a thermostat, or a combination thereof. Alternatively, it is possible to provide a control means, a humidity sensor and a temperature sensor as separate components, or it is possible to integrate a humidity sensor and a temperature sensor and provide a control means as a separate component.

It will be obvious to a person skilled in the art that the inventive concept can be implemented in various ways. The invention and its embodiments are not limited to the examples described above but may vary within the scope of the claims.

## Claims

1. An electrical assembly comprising:
a housing (2);
a fan means (4) adapted to generate an air flow inside the housing (2);
a sensor means (8) adapted to detect conditions inside the housing (2), the conditions comprising humidity and/or temperature; and
a control means (CTRL) adapted to control the fan means (4), the control means (CTRL) being adapted to receive information from the sensor means (8), and to perform at least one humidity prevention action in a predetermined humidity situation detected based on the information received from the sensor means (8), the at least one humidity prevention action comprises increasing power of the fan means (4),
**characterized in that** the housing (2) is an enclosed housing such that there is substantially no airflow between the inside of the housing (2) and the outside of the housing (2).

2. An electrical assembly according to claim 1, **characterized in that** in connection with the at least one humidity prevention action the control means (CTRL) is adapted to control a power of the fan means as a response to a desired humidity prevention power.

3. An electrical assembly according to claim 1 or 2, **characterized in that** the sensor means (8) comprises a humidity sensor (85) adapted to detect humidity inside the housing (2), and the predetermined humidity situation comprises a situation where humidity inside the housing (2) exceeds a predetermined humidity limit value.

4. An electrical assembly according to any one of claims 1 to 3, **characterized in that** the sensor means (8) comprises a first temperature sensor (81) adapted to detect temperature inside the housing (2), and a second temperature sensor (82) adapted to detect ambient temperature present outside the housing (2), and the predetermined humidity situation comprises a situation where a difference between a temperature inside the housing (2) and an ambient temperature is less than a predetermined temperature difference.

5. An electrical assembly according to any one of claims 1 to 4, **characterized in that** the electrical assembly comprises a heating resistor means (9) located inside the housing (2) and adapted for heating inside the housing (2), the control means (CTRL) is adapted to control the heating resistor means (9), and the at least one humidity prevention action comprises turning on the heating resistor means (9) at least partially.

6. An electrical assembly according to any one of claims 1 to 5, **characterized in that** the electrical assembly comprises a power conversion means (10) located inside the housing (2), the power conversion means (10) being adapted to convert electric energy from one form to another, and the control means (CTRL) is adapted to control the power conversion means (10).

7. An electrical assembly according to claim 6, **characterized in that** the at least one humidity prevention action comprises turning on the power conversion means (10) when a predetermined humidity situation occurs while the power conversion means (10) is in off state and is not required to convert electric energy.

8. An electrical assembly according to any one of claims 1 to 7, **characterized in that** the sensor means and the control means are at least partially integrated, wherein the electrical assembly comprises condition-sensitive switch means adapted to control the fan means, the condition-sensitive switch means comprising a humidistat or a thermostat, or a combination thereof.

9. An electrical assembly according to any one of claims 1 to 3, **characterized in that** the sensor means (8) comprises a first temperature sensor (81) adapted to detect temperature inside the housing (2), and the control means (CTRL) is adapted to store information about an operating temperature range of the fan means (4) and to utilize said information when selecting at least one humidity prevention action.

10. A method for preventing humidity in an electrical assembly, the electrical assembly comprising a housing (2) and a fan means (4) adapted to generate an air flow inside the housing (2), the housing (2) being an enclosed housing such that there is substantially no air flow between the inside of the housing (2) and the outside of the housing (2), wherein the method comprises:
detecting conditions inside the housing (2), the conditions comprising temperature and/or humidity; and
increasing power of the fan means (4) if a predetermined humidity situation is detected inside the housing (2).

11. A method according to claim 10, wherein detecting conditions inside the housing (2) comprises detecting humidity inside the housing (2), and the predetermined humidity situation comprises a situation where humidity inside the housing (2) exceeds a predetermined humidity limit value.

12. A method according to claim 10, wherein detecting conditions inside the housing (2) comprises detecting temperature inside the housing (2), and the method further comprises detecting ambient temperature present outside the housing (2), and the predetermined humidity situation comprises a situation where a difference between a temperature inside the housing (2) and an ambient temperature is less than a predetermined temperature difference limit value.

## Patentansprüche

1. Elektrische Baugruppe, die umfasst:
ein Gehäuse (2);
eine Gebläse-Einrichtung (4), die zum Erzeugen eines Luftstroms
im Inneren des Gehäuses (2) eingerichtet ist;
eine Sensor-Einrichtung (8), die zum Erfassen von Bedingungen im Inneren des Gehäuses (2) eingerichtet ist, wobei die Bedingungen Feuchtigkeit und/oder Temperatur einschließen; und
eine Steuerungs-Einrichtung (CTRL), die zum Steuern der Gebläse-Einrichtung (4) eingerichtet ist, wobei die Steuerungs-Einrichtung (CTRL) so eingerichtet ist, dass sie Informationen von der Sensor-Einrichtung (8) empfängt und wenigstens einen Vorgang zur Verhinderung von Feuchtigkeit in einer vorgegebenen Feuchtigkeits-Situation durchführt, die auf Basis der von der Sensor-Einrichtung (8) empfangenen Informationen erfasst wird, und der wenigstens eine Vorgang zur Verhinderung von Feuchtigkeit Erhöhen von Leistung der Gebläse-Einrichtung (4) umfasst,
**dadurch gekennzeichnet, dass** das Gehäuse (2) ein abgeschlossenes Gehäuse ist, so dass im Wesentlichen kein Luftstrom zwischen der Innenseite des Gehäuses (2) und der Außenseite des Gehäuses (2) stattfindet.

2. Elektrische Baugruppe nach Anspruch 1,
**dadurch gekennzeichnet, dass** die Steuerungs-Einrichtung (CTRL) so eingerichtet ist, dass sie in Verbindung mit dem wenigstens einen Vorgang zur Verhinderung von Feuchtigkeit eine Leistung der Gebläse-Einrichtung als eine Reaktion auf eine gewünschte Leistung zur Verhinderung von Feuchtigkeit steuert.

3. Elektrische Baugruppe nach Anspruch 1 oder 2,
**dadurch gekennzeichnet, dass** die Sensor-Einrichtung (8) einen Feuchtigkeits-Sensor (85) umfasst, der zum Erfassen von Feuchtigkeit im Inneren des Gehäuses (2) eingerichtet ist, und die vorgegebene Feuchtigkeits-Situation eine Situation umfasst, in der Feuchtigkeit im Inneren des Gehäuses (2) einen vorgegebenen Feuchtigkeits-Grenzwert überschreitet.

4. Elektrische Baugruppe nach einem der Ansprüche 1 bis 3, **dadurch gekennzeichnet, dass** die Sensor-Einrichtung (8) einen ersten Temperatur-Sensor (81), der zum Erfassen von Temperatur im Inneren des Gehäuses (2) eingerichtet ist, sowie einen zweiten Temperatur-Sensor (82) umfasst, der zum Erfassen von Umgebungstemperatur eingerichtet ist, die außerhalb des Gehäuses (2) herrscht, und die vorgegebene Feuchtigkeits-Situation eine Situation umfasst, in der eine Differenz zwischen einer Temperatur im Inneren des Gehäuses (2) und einer Umgebungstemperatur unter einer vorgegebenen Temperaturdifferenz liegt.

5. Elektrische Baugruppe nach einem der Ansprüche 1-4, **dadurch gekennzeichnet, dass** die elektrische Baugruppe eine Heizwiderstands-Einrichtung (9) umfasst, die sich im Inneren des Gehäuses (2) befindet und zum Erwärmen des Inneren des Gehäuses (2) eingerichtet ist, und die Steuerungs-Einrichtung (CTRL) zum Steuern der Heizwiderstands-Einrichtung (9) eingerichtet ist und der wenigstens eine Vorgang zur Verhinderung von Feuchtigkeit wenigstens teilweises Anschalten der Heizwiderstands-Einrichtung (9) umfasst.

6. Elektrische Baugruppe nach einem der Ansprüche 1 bis 5, **dadurch gekennzeichnet, dass** die elektrische Baugruppe eine Energieumwandlungs-Einrichtung (10) umfasst, die sich im Inneren des Gehäuses (2) befindet, wobei die Energieumwandlungs-Einrichtung (10) zum Umwandeln elektrischer Energie von einer Form in eine andere eingerichtet ist und die Steuerungs-Einrichtung (CTRL) zum Steuern der Energieumwandlungs-Einrichtung (10) eingerichtet ist.

7. Elektrische Baugruppe nach Anspruch 6,
**dadurch gekennzeichnet, dass** der wenigstens eine Vorgang zur Verhinderung von Feuchtigkeit umfasst, dass die Energieumwandlungs-Einrichtung (10) angeschaltet wird, wenn eine vorgegebene Feuchtigkeits-Situation eintritt, während sich die Energieumwandlungs-Einrichtung (10) in abgeschaltetem Zustand befindet und nicht zum Umwandeln elektrischer Energie erforderlich ist.

8. Elektrische Baugruppe nach einem der Ansprüche 1 bis 7, **dadurch gekennzeichnet, dass** die Sensor-Einrichtung und die Steuerungs-Einrichtung wenigstens teilweise integriert sind, wobei die elektrische Baugruppe eine bedingungsabhängige Schalt-Einrichtung umfasst, die zum Steuern der Gebläse-Einrichtung eingerichtet ist, und die bedingungsabhängige Schalt-Einrichtung einen Humidistat oder einen Thermostat oder eine Kombination aus diesen umfasst.

9. Elektrische Baugruppe nach einem der Ansprüche 1 bis 3, **dadurch gekennzeichnet, dass** die Sensor-Einrichtung (8) einen ersten Temperatur-Sensor (81) umfasst, der zum Erfassen von Temperatur im Inneren des Gehäuses (2) eingerichtet ist, und die Steuerungs-Einrichtung (CTRL) so eingerichtet ist, dass sie Informationen über einen Betriebstemperatur-Bereich der Gebläse-Einrichtung (4) speichert und die Informationen beim Auswählen wenigstens eines Vorgangs zur Verhinderung von Feuchtigkeit nutzt.

10. Verfahren zum Verhindern von Feuchtigkeit in einer elektrischen Baugruppe, wobei die elektrische Baugruppe ein Gehäuse (2) sowie eine Gebläse-Einrichtung (4) umfasst, die zum Erzeugen eines Luftstroms im Inneren des Gehäuses (2) eingerichtet ist, das Gehäuse (2) ein abgeschlossenes Gehäuse ist, so dass im Wesentlichen kein Luftstrom zwischen der Innenseite des Gehäuses (2) und der Außenseite des Gehäuses (2) stattfindet, und das Verfahren umfasst:
Erfassen von Bedingungen im Inneren des Gehäuses (2), wobei die Bedingungen Temperatur und/oder Feuchtigkeit einschließen; und
erhöhen von Leistung der Gebläse-Einrichtung (4), wenn eine vorgegebene Feuchtigkeits-Situation im Inneren des Gehäuses (2) erfasst wird.

11. Verfahren nach Anspruch 10, wobei Erfassen von Bedingungen im Inneren des Gehäuses (2) Erfassen von Feuchtigkeit im Inneren des Gehäuses (2) umfasst, und die vorgegebene Feuchtigkeits-Situation eine Situation umfasst, in der Feuchtigkeit im Inneren des Gehäuses (2) einen vorgegebenen Feuchtigkeits-Grenzwert überschreitet.

12. Verfahren nach Anspruch 10, wobei Erfassen von Bedingungen im Inneren des Gehäuses (2) Erfassen von Temperatur im Inneren des Gehäuses (2) umfasst und das Verfahren des Weiteren Erfassen von Umgebungstemperatur umfasst, die außerhalb des Gehäuses (2) herrscht, und die vorgegebene Feuchtigkeits-Situation eine Situation umfasst, in der eine Differenz zwischen einer Temperatur im Inneren des Gehäuses (2) und einer Umgebungstemperatur unter einem vorgegebenen Temperaturdifferenz-Grenzwert liegt.

## Revendications

1. Ensemble électrique comprenant :
un boîtier (2) ;
des moyens de ventilateur (4) adaptés pour générer un flux d'air à l'intérieur du boîtier (2) ;
des moyens de capteur (8) adaptés pour détecter des conditions à l'intérieur du boîtier (2), les conditions comprenant de l'humidité et/ou une température ; et
des moyens de commande (CTRL) adaptés pour commander les moyens de ventilateur (4), les moyens de commande (CTRL) étant adaptés pour recevoir des informations provenant des moyens de capteur (8), et pour effectuer au moins une action de prévention contre l'humidité lors d'une situation d'humidité prédéterminée détectée sur la base des informations reçues des moyens de capteur (8), la au moins une action de prévention contre l'humidité comprend une augmentation de la puissance des moyens de ventilateur (4),
**caractérisé en ce que** le boîtier (2) est un boîtier fermé de telle sorte qu'il n'y a pratiquement aucun flux d'air entre l'intérieur du boîtier (2) et l'extérieur du boîtier (2).

2. Ensemble électrique selon la revendication 1, **caractérisé en ce que**, en relation avec la au moins une action de prévention contre l'humidité, les moyens de commande (CTRL) sont adaptés pour commander une puissance des moyens de ventilateur en réponse à une action de prévention contre l'humidité voulue.

3. Ensemble électrique selon la revendication 1 ou 2, **caractérisé en ce que** les moyens de capteur (8) comprennent un capteur d'humidité (85) adapté pour détecter de l'humidité à l'intérieur du boîtier (2), et la situation d'humidité prédéterminée comprend une situation dans laquelle l'humidité à l'intérieur du boîtier (2) dépasse une valeur limite d'humidité prédéterminée.

4. Ensemble électrique selon l'une quelconque des revendications 1 à 3, **caractérisé en ce que** les moyens de capteur (8) comprennent un premier capteur de température (81) adapté pour détecter une température à l'intérieur du boîtier (2), et un second capteur de température (82) adapté pour détecter une température ambiante présente à l'extérieur du boîtier (2), et la situation d'humidité prédéterminée comprend une situation dans laquelle une différence entre une température à l'intérieur du boîtier (2) et une température ambiante est inférieure à une différence de température prédéterminée.

5. Ensemble électrique selon l'une quelconque des revendications 1 à 4, **caractérisé en ce que** l'ensemble électrique comprend des moyens de résistance chauffante (9) situés à l'intérieur du boîtier (2) et adaptés pour chauffer l'intérieur du boîtier (2), les moyens de commande (CTRL) sont adaptés pour commander les moyens de résistance chauffante (9), et la au moins une action de prévention conte l'humidité comprend l'activation au moins partielle des moyens de résistance chauffante (9).

6. Ensemble électrique selon l'une quelconque des revendications 1 à 5, **caractérisé en ce que** l'ensemble électrique comprend des moyens de conversion de puissance (10) situés à l'intérieur du boîtier (2), les moyens de conversion de puissance (10) étant adaptés pour convertir de l'énergie électrique d'une forme en une autre, et les moyens de commande (CTRL) sont adaptés pour commander les moyens de conversion de puissance (10).

7. Ensemble électrique selon la revendication 6, **caractérisé en ce que** la au moins une action de prévention contre l'humidité comprend l'activation des moyens de conversion de puissance (10) lorsqu'une situation d'humidité prédéterminée se produit alors que les moyens de conversion de puissance (10) sont dans un état désactivé et ne sont pas nécessaires pour convertir de l'énergie électrique.

8. Ensemble électrique selon l'une quelconque des revendications 1 à 7, **caractérisé en ce que** les moyens de capteur et les moyens de commande sont au moins partiellement intégrés, dans lequel l'ensemble électrique comprend des moyens de commutation sensibles aux conditions adaptés pour commander les moyens de ventilateur, les moyens de commutation sensibles aux conditions comprenant un hygrostat ou un thermostat, ou une combinaison de ceux-ci.

9. Ensemble électrique selon l'une quelconque des revendications 1 à 3, **caractérisé en ce que** les moyens de capteur (8) comprennent un premier capteur de température (81) adapté pour détecter une température à l'intérieur du boîtier (2), et les moyens de commande (CTRL) sont adaptés pour stocker des informations concernant une plage de températures de fonctionnement des moyens de ventilateur (4) et pour utiliser lesdites informations lors de la sélection d'au moins une action de prévention contre l'humidité.

10. Procédé de prévention contre l'humidité dans un ensemble électrique, l'ensemble électrique comprenant un boîtier (2) et des moyens de ventilateur (4) adaptés pour générer un flux d'air à l'intérieur du boîtier (2), le boîtier (2) étant un boîtier fermé de sorte qu'il n'y a sensiblement aucun flux d'air entre l'intérieur du boîtier (2) et l'extérieur du boîtier (2), dans lequel le procédé comprend de :
détecter des conditions à l'intérieur du boîtier (2), les conditions comprenant une température et/ou de l'humidité ; et
augmenter la puissance des moyens de ventilateur (4) si une situation d'humidité prédéterminée est détectée à l'intérieur du boîtier (2).

11. Procédé selon la revendication 10, dans lequel la détection de conditions à l'intérieur du boîtier (2) comprend la détection d'humidité à l'intérieur du boîtier (2), et la situation d'humidité prédéterminée comprend une situation dans laquelle de l'humidité à l'intérieur du boîtier (2) dépasse une valeur limite d'humidité prédéterminée.

12. Procédé selon la revendication 10, dans lequel la détection de conditions à l'intérieur du boîtier (2) comprend la détection d'une température à l'intérieur du boîtier (2), et le procédé comprend en outre la détection d'une température ambiante présente à l'extérieur du boîtier (2), et la situation d'humidité prédéterminée comprend une situation dans laquelle une différence entre une température à l'intérieur du boîtier (2) et une température ambiante est inférieure à une valeur limite de différence de température prédéterminée.
